# EUROPÄISCHE PATENTSCHRIFT

(11) **EP 2 201 830 B1**
(45) Veröffentlichungstag und Bekanntmachung des Hinweises auf die Patenterteilung: **28.06.2017**
(21) Anmeldenummer: 08786840.2
(22) Anmeldetag: 04.08.2008
(51) Int. Cl.: H05K 5/06, H05K 1/14, B60R 16/023

(54) **MODUL FÜR EINE INTEGRIERTE STEUERELEKTRONIK MIT VEREINFACHTEM AUFBAU**
MODULE FOR INTEGRATED CONTROL ELECTRONICS HAVING SIMPLIFIED DESIGN
MODULE POUR UNE ÉLECTRONIQUE DE COMMANDE INTÉGRÉE À CONSTRUCTION SIMPLIFIÉE

(30) Priorität: 07.09.2007 DE 102007042593
(43) Veröffentlichungstag der Anmeldung: 30.06.2010
(73) Patentinhaber: Continental Automotive GmbH, 30165 Hannover (DE)
(72) Erfinder: LOIBL, Josef, 93077 Bad Abbach (DE); SMIRRA, Karl, 83512 Wasserburg (DE); PREUSCHL, Thomas, 93161 Eilsbrunn (DE); ROBIN, Hermann-Josef, 93053 Regensburg (DE)
(86) Internationale Anmeldenummer: PCT/EP2008/060227
(87) Internationale Veröffentlichungsnummer: WO 2009/033890

(56) Entgegenhaltungen:
- EP-A- 0 598 914
- EP-A- 1 093 326
- DE-C1- 10 100 823
- JP-A- 4 078 190
- JP-A- 11 097 820

## Beschreibung

Die Erfindung betrifft ein Modul für eine integrierte Steuerelektronik gemäß dem Oberbegriff des Patentanspruchs 1 sowie ein Verfahren zur Herstellung eines solchen Moduls, insbesondere für Getriebe- oder Motorsteuerungen in der Automobilindustrie.

### Stand der Technik

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu integrierten mechatronischen Steuerungen, also zur Integration von Steuerelektronik und den zugehörigen elektronischen Komponenten wie Sensoren oder Ventile in das Getriebe, den Motor oder das Bremssystem. Steuergeräte weisen also im Allgemeinen eine Vielzahl an elektronischen Komponenten auf, welche in Verbindung mit anderen Komponenten außerhalb des Steuergerätes stehen. Bei solchen "Vorort-Elektroniken" sind diese Steuerungen nicht mehr in einem separaten geschützten Elektronikraum untergebracht und müssen daher entsprechenden Umwelteinflüssen und mechanischen, thermischen sowie chemischen Beanspruchungen standhalten.

Sie werden zu diesem Zweck normalerweise in spezielle Gehäuse eingesetzt. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig. Aus der Druckschrift DE 101 00 823 C1 ist ein dichter Elektronikraum für ein Motor- oder Getriebeintegriertes Kraftfahrzeug-Steuergerät bekannt, der in einer wannenförmigen Vertiefung einer Trägerplatte realisiert ist.

Der übliche Aufbau für solche integrierten mechatronischen Anwendungen besteht aus einem keramischen Substrat, das die verschiedenen elektronischen Bauteile der zentralen Steuerungseinheit beinhaltet. Dieses keramische Substrat wird mittels Bonden mit starren oder flexiblen Leiterplatten verbunden, um die Anbindung der peripheren Komponenten an die Zentraleinheit zu ermöglichen. Wie schon beschrieben sind zum Beispiel Getriebesteuerungsmodule im Getriebeölsumpf untergebracht und daher vollständig mit Öl und der darin enthaltenen leitenden Kontamination umgeben. Dies können zum Beispiel Kontaminationen aus Verzahnungsabrieb, Zerspanungsreste aus Fertigungsprozessen oder unzulänglichen Wasch- und Reinigungsprozessen des Getriebegehäuses und/oder der verbauten Komponenten sein. Zum notwendigen Schutz vor solcher Kontamination, vor Beschädigungen und Leiterbahn- oder Bondkurzschlüssen wird eine Verdeckelung, üblicherweise als metallischer, nicht-metallischer oder metallisierter Gehäusedeckel, auf die Gehäusebodenplatte aufgebracht und hermetisch abgedichtet. Dieser Gesamtverbund aus keramischem Substrat, Leiterplatten und deren Anbindung zur elektronischen Verbindung der Peripherie sowie hermetisch dichtem Gehäuse ist ein signifikanter Kostentreiber. Gerade die bevorzugt als Schaltungsträger eingesetzten LTCCs (Low Temperature co-fired Ceramics), die zur mechanischen Stabilität und thermischen Anbindung auf eine Grundplatte aufgebracht werden, stellen einen großen Kostenfaktor des gesamten Bauteils dar. Ihre elektronische Verbindung über flexible Leiterplatten oder Stanzgitter zu den außerhalb des abgedichteten Gehäuses liegenden Komponenten ist zudem aufwendig und daher kostenträchtig.

### Aufgabenstellung

Aufgabe der Erfindung ist es daher, ein Modul für eine integrierte Steuerelektronik mit einem Gehäuse, einer darin untergebrachten zentralen Steuerungseinheit umfassend verschiedene elektronische Bauteile und einer elektronischen Verbindung zwischen dem Gehäuseinnenraum und dem Gehäuseaußenraum bereit zu stellen, welche eine einfache und flexible Verbindung zu außerhalb des Gehäuses liegenden Komponenten ermöglicht, wobei die elektronische Verbindung und die zentrale Steuerungseinheit einen vereinfachten und daher kostengünstigeren Aufbau aufweisen und gleichzeitig sicher vor Kurzschluss und/oder leitender Kontamination geschützt sind.

Dies wird erfindungsgemäß mit einer Vorrichtung entsprechend des Patentanspruchs 1 sowie mit einem Verfahren zur Herstellung einer solchen Vorrichtung gemäß Anspruch 7 erreicht. Erfindungsgemäß wird ein Leiterplattenaufbau als Schaltungsträger eingesetzt, der weiterhin die elektronischen Bauteile der zentralen Steuerungseinheit trägt und zudem die Ableitung der durch die Leistungseinheiten erzeugten Wärme über den wannenförmig ausgestalteten Gehäuseboden sicherstellt. Der Einsatz teurer keramischer Schaltungsträger wie beispielsweise LTCCs (Low Temperature co-fired Ceramics), keramische Dickschichtsubstrate oder HTCCs (High Temperature co-fired Ceramics) und deren Anbindung mittels starrer oder flexibler Leiterplatten an die peripheren Komponenten ist damit nicht mehr notwendig, kann jedoch mit dem erfindungsgemäßen Gehäusekonzept dennoch kostengünstig und vereinfacht vorgenommen werden. Durch das erfindungsgemäße Konzept kann vorteilhaft die Außenkontur des elektronischen Bauteils durch einen Stanzprozess variabel an die applikationsspezifischen Vorgaben angepasst werden. Hinsichtlich der Signal- und Stromverteilungskomponente kann neben der Realisierung von Kreuzungen und sehr feiner Leiterbahnstrukturen auch eine flächenoptimierte Struktur mit einer hohen Anzahl von Anschlusskontakten bereitgestellt werden.

Es können als Signal- und Stromverteilungskomponenten erfindungsgemäß beispielsweise vergleichsweise kostengünstige PCB-Leiterplatten (Printed Circuit Bords) eingesetzt werden. Gleichermaßen ist es möglich, als Signal- und Stromverteilungskomponente mehrlagige flexible Leiterplatten einzusetzen. Die Signal- und Stromverteilungskomponente ist bevorzugt zwei- oder mehrlagig. So kann bevorzugt eine zweilagige PCB-Leiterplatte mit einem elektrisch isolierenden Kern und einer Kupferbeschichtung eingesetzt werden.

Besonders bevorzugt wird eine doppelseitige PCB zur Signal-und Stromverteilung an beispielsweise Stecker, Sensoren oder Aktuatoren eingesetzt, die aus einem elektrisch isolierenden Kern und einer beidseitig aufgebrachten leitenden Beschichtung, bevorzugt aus Kupfer, aufgebaut ist. Zur Vermeidung von Kurzschlüssen können offene Leiterbahnbereiche durch einen Lötstopplack abgedeckt werden.

Dieser Aufbau ist relativ dünn und ermöglicht vorteilhafterweise die Ausbildung von dreidimensionalen Strukturen durch Biegen einzelner PCB-Bereiche. Dies ist für einen Einsatz beispielsweise in einem Getriebe sehr hilfreich, da unter anderem verschiedene Kontaktierlevel erforderlich sind. Gleichzeitig sind im Gegensatz zu einlagigen flexiblen Leiterplatten zudem Kreuzungen der Verteilungspfade möglich.

Weiterhin bevorzugt weist die mehrlagige Signal- und Stromverteilungskomponente ihrerseits verschiedene Kontaktstellen zur elektronischen Anbindung der peripheren Komponenten auf. Wie vorstehend bereits beschrieben können sowohl Anschlüsse für Stecker als auch für Sensoren, Ventile und andere Aktuatoren vorgesehen werden, was eine große Flexibilität des Gesamtaufbaus des elektronischen Bauteils ermöglicht.

In einer bevorzugten Ausgestaltung kann die elektronische Anbindung der außerhalb des Gehäuses liegenden Komponenten mittels Einpresstechnik, Löten und/oder Laserschweißen ausgeführt werden.

Über so genannte Pressfit-Pins in der Einpresstechnik kann eine variable, einfache und sichere elektronische Verbindung zu den peripheren Komponenten hergestellt werden. Gleichermaßen bevorzugt kann diese Verbindung je nach Anforderung der Komponente auch mittels Laserschweißen hergestellt werden. Generell ist die Art der Verbindungsherstellung nicht kritisch und kann nach den jeweiligen Voraussetzungen der Komponenten und der vorhandenen Prozesseinrichtungen aus dem Fachmann bekannten Verfahren ausgewählt werden. So können die Verbindungen lösbar beispielsweise als Stecker oder nicht lösbar durch beispielsweise Löten oder Schweißen hergestellt werden. Die Leiterplatte wird besonders bevorzugt direkt mit den Signalgebern und -empfängern (insbesondere Sensoren, Ventile, etc.) außerhalb des Gehäuses verbunden.

Der Schaltungsträger kann einstückig oder mehrstückig ausgeführt sein.

Bevorzugt ist der Schaltungsträger erfindungsgemäß eine mehrlagige PCB Leiterplatte, wobei durch partielle Tiefenfräsung flexible Bereiche in den Randbereichen ausgebildet werden, die eine Biegung dieser Bereiche nach oben ermöglichen. So kann dort eine dreidimensionale Struktur gebildet werden, die eine Anpassung an den wannenförmigen Aufbau des Gehäusebodens erlaubt.

Die Tiefenfräsung kann mittels Laserabtrag oder Fräsen erfolgen. Sie kann den gesamten Randbereich des Schaltungsträgers bis zu den Kanten umfassen. Gleichermaßen kann sie aber auch als Nut ausgebildet werden, so dass an den Anschlussbereichen der Kanten die PCB Leiterplatte in ursprünglicher Dicke verbleibt. Auf diese Weise ist die nötige Flexibilität zur Ausbildung der dreidimensionalen Strukturen gegeben, wobei gleichzeitig die Bearbeitungszeiten durch das Fräsen minimiert werden können.

In einer anderen bevorzugten Ausgestaltung der vorliegenden Erfindung können die elektronischen Bauteile der zentralen Steuerungselektronik in die mehrlagige PCB-Leiterplatte des Schaltungsträgers innen liegend oder auf der Oberfläche integriert sein. Als elektronische Bauteile können beispielsweise gedruckte Widerstände oder Kapazitäten, die auch als Leitungen oder Flächen ausgeführt sein können, sowie Chips oder komplexe Chips (ICs) eingesetzt werden. Auch die Verarbeitung von so genannten Bare-Chips, die gebondet werden, und von gehäusten Bauelementen, die geklebt oder gelötet werden, ist möglich. Auf diese Weise sind eine erhöhte Langzeitstabilität und eine ausgezeichnete Anbindung an die Signal- und Potentialverteilungspfade des Schaltungsträgers gewährleistet.

Die elektronischen Bauteile der zentralen Steuerungselektronik können bevorzugt mittels Lötverfahren oder Kleben auf der mehrlagigen Leiterplatte befestigt und/oder kontaktiert sein. Das Lötverfahren kann beispielsweise ein Reflow-Lötverfahren sein.

Alternativ oder zusätzlich können die elektronischen Bauteile der zentralen Steuerungselektronik darüber hinaus mit der mehrlagigen Leiterplatte des Schaltungsträgers vergossen sein.

Diese industriellen Verfahren lassen sich leicht automatisieren und damit auch in bereits bestehende Prozesse eingliedern. Durch den wannenförmigen Aufbau des Gehäusebodens und des darin angeordneten Schaltungsträgers mit nach oben gebogenen Rand- und Anschlussbereichen ist das Vergießen der elektronischen Bauelemente mit der PCB-Leiterplatte beispielsweise mit Silgel im Vergleich zu den bisher bekannten Aufbauten deutlich vereinfacht, da das Gel bei noch geöffnetem Gehäuse einfach in die Wanne eingefüllt werden kann. Die Anordnung ist leicht zu evakuieren und außerdem kann eine Blasenbildung gut vermieden werden. Damit kann vorliegend im Gegensatz zum Stand der Technik auf thixotropierende Silgele verzichtet werden.

In einer weiteren Ausgestaltung der Erfindung kann ein keramisches Substrat in Verbindung mit einer einstückig oder mehrstückig ausgestalteten PCB-Leiterplatte als Schaltungsträger eingesetzt werden.

Hierbei hat die mehrlagige PCB-Leiterplatte nur mehr die Aufgabe, die Anbindung an die Signal- Stromverteilungskomponente und die dreidimensionale Ausgestaltung im Randbereich zur Anpassung an den wannenförmigen Gehäuseboden sicher zu stellen. Daher können hier sehr kostengünstige PCB Leiterplatten verwendet werden, die je nach Anforderung einstückig als Rahmen für das keramische Substrat oder mehrstückig eingesetzt werden können. Vorzugsweise werden in beiden Varianten zweilagige Leiterplatten mit einem elektrisch isolierenden Kern und einer Kupferschicht verwendet.

Der wannenförmige Gehäuseboden besteht bevorzugter Weise aus einem Stanzbiegeteil aus einem metallischen Material, besonders bevorzugt ist er aus Aluminium. In einer bevorzugten Ausführungsform der Erfindung wird der Schaltungsträger in die metallische Bodenwanne eingesetzt und mit einem Wärmeleitkleber fest und temperaturoptimiert verklebt. Dies stellt neben einer guten Wärmeableitung eine verlässliche und kostengünstige Fixierung sicher.

Zudem wird auf diese Weise eine Abdichtung des Elektronikraums nach unten beispielsweise zum Getriebeöl hin erreicht.

Besonders bevorzugt können an den Randbereichen des wannenförmigen Gehäusebodens Noppen oder andere Befestigungselemente ausgeprägt sein, die einen definierten Sitz des Schaltungsträgers sicherstellen.

Zur Herstellung eines erfindungsgemäßen Gehäusekonzepts für ein elektronisches Steuergerät wird ein Schaltungsträger mit den elektronischen Bauteilen der zentralen Steuerungselektronik bestückt, in einen wannenförmigen Gehäuseboden eingebracht, optional mit einem Vergussmaterial vergossen und eine darüber angeordnete Signal- und Stromverteilungskomponente wird in einem Schritt sowohl elektrisch mit dem Schaltungsträger als auch mechanisch mit den wannenförmigen Gehäuseboden verbunden.

Der Schaltungsträger kann optional mittels Wärmeleitkleber an die Innenseite des wannenförmigen Gehäusebodens befestigt werden. Bevorzugt werden auch die nach oben gebogenen Randbereiche des Schaltungsträgers mit den Anschlussstellen für die elektrische Anbindung an die Signal- und Stromverteilungskomponente mittels Wärmeleitkleber an die Oberseiten der Gehäusewanne geklebt, nachdem sie optional mittels Befestigungselementen wie beispielsweise ausgebildeten Noppen an der Wanne definiert vorbefestigt wurden. Bis zur Aushärtung des Klebers ist dadurch vorteilhafterweise ein leichter Höhenausgleich möglich, so dass die Signal- und Stromverteilungskomponenten bei der Montage auf die entsprechenden Randbereiche des Schaltungsträgers flächig aufliegt.

Wenn ein größerer Toleranzausgleich erzielt werden soll, kann zwischen dem wannenförmigen Gehäuse und dem Schaltungsträger ein Dämpfungselement vorgesehen werden. Zur weiteren mechanischen Stabilisierung der Kontaktstellen zwischen Schaltungsträger und Signal- und Stromverteilungskomponente kann um die Kontaktstellen herum zusätzlich eine Laminierung beispielsweise mit zweiseitigem Acrylklebeband vorgesehen werden.

Nach dem Einsetzen des Schaltungsträgers in den wannenförmigen Gehäuseboden kann die Anordnung optional durch Einfüllen einer Vergussmasse wie zum Beispiel Silgel versiegelt werden. Die mechanische Verbindung zwischen Gehäuseboden, Schaltungsträger und darüber angeordneter Signal- und Stromverteilungskomponenten wird besonders bevorzugt in einem kombinierten Schritt mit der elektrischen Anbindung zwischen den Komponenten hergestellt. Dazu werden die elektrischen Anbindungen mittels Löten und gleichzeitig die mechanische Anbindung mittels Laminieren ausgeführt.

Auf diese Weise ist es vorteilhafterweise möglich, ein mechanisch robustes Gehäusekonzept zu realisieren, das es ermöglicht, den Vergussschritt noch im offenen Zustand auszuführen. Weiterhin vorteilhaft ist aufgrund der Verringerung der Teileanzahl gegenüber den bisherigen Aufbauten des Standes der Technik und der Integration von zwei Prozessschritten in einen einzigen eine vereinfachte Montage sicher gestellt. Darüber hinaus kann durch die Verlässlichkeit des Laminierprozesses der sonst übliche Dichtheitstest entfallen.

Bevorzugt wird das erfindungsgemäße Gehäusekonzept für eine integrierte Getriebesteuerung eines Kraftfahrzeugs verwendet.

Die Erfindung wird nachfolgend in beispielhafter Weise anhand von mehreren Ausführungsvarianten in Verbindung mit den Zeichnungen erläutert, ohne darauf beschränkt zu sein.
In diesen zeigt:
- **Fig. 1**: eine perspektivische Draufsicht auf einen erfindungsgemäßen Schaltungsträger für ein Gehäusekonzept einer integrierte Steuerungselektronik,
- **Fig. 2**: eine Detailansicht des Randbereichs eines erfindungsgemäßen Schaltungsträgers aus Fig. 1,
- **Fig. 3**: eine Detailansicht eines alternativ ausgestalteten Randbereichs eines erfindungsgemäßen Schaltungsträgers aus Fig. 1,
- **Fig. 4**: eine perspektivische Draufsicht auf eine Signal- und Stromverteilungskomponente des erfindungsgemäßen Gehäusekonzepts,
- **Fig. 5**: eine perspektivische Schnittansicht auf ein erfindungsgemäßes Gehäusekonzept,
- **Fig. 6**: eine explodierte Detailansicht auf den Randbereich eines erfindungsgemäßen Gehäusekonzepts,
- **Fig. 7**: eine Detail-Schnittansicht eines Schaltungsträgers des erfindungsgemäßen Gehäusekonzepts,
- **Fig. 8**: eine Detail-Schnittansicht von einer alternativen Variante eines Gehäusekonzepts, das keine Ausführungsform der Erfindung darstellt.
- **Fig. 9**: eine explodierte perspektivische Draufsicht einer weiteren Ausgestaltung die keine Ausführungsform der Erfindung darstellt und
- **Fig. 10 und Fig. 11**: Darstellungen zweier Ausgestaltungen eines Gehäusekonzepts mit keramischen Substraten als Schaltungsträgern.

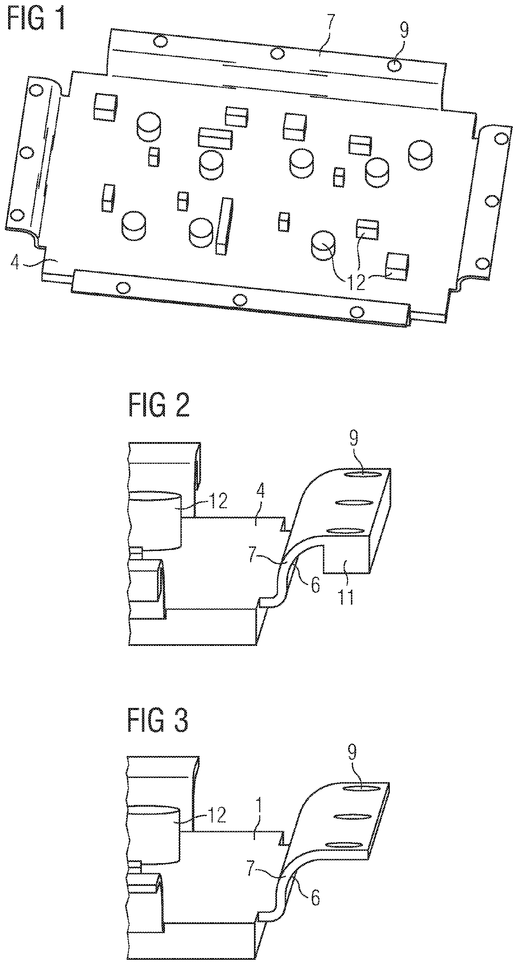

**Fig. 1** zeigt eine perspektivische Draufsicht auf einen Schaltungsträger **4** des erfindungsgemäßen Gehäusekonzepts **1** für eine integrierte Steuerungselektronik bestückt mit elektronischen Bauteilen **12.** Die Randbereiche der als Schaltungsträger eingesetzten mehrlagigen PCB-Leiterplatte **4** sind erfindungsgemäß nach oben gebogen **7** und weisen an der Oberseite Kontaktstellen **9** in Form von Lötkontakten auf. Die Biegung der PCB-Leiterplatte wird durch eine Tiefenfräsung der entsprechenden Bereiche erzielt. Dieser Materialabtrag kann durch Fräsen oder durch Laserabtrag erreicht werden.

**Fig. 2** und **Fig. 3** zeigen Detailausschnitte der Randbereiche 7 eines Schaltungsträgers **4** für ein erfindungsgemäßes Gehäusekonzept **1.** Die Tiefenfräsung **6** in **Fig. 2** ist als Nut ausgebildet, so dass im Kantenbereich unterhalb der Kontaktstellen **9** für die elektrische Kontaktierung die ursprüngliche Dicke des Schaltungsträgers **11** erhalten ist. Alternativ zeigt **Fig. 3** eine Tiefenfräsung **6,** die einen gleichmäßigen Materialabtrag bis zur Kante auch unterhalb der Kontaktstellen **9** zur elektrischen Anbindung der Signal- und Stromverteilungskomponente (nicht gezeigt) vorsieht.

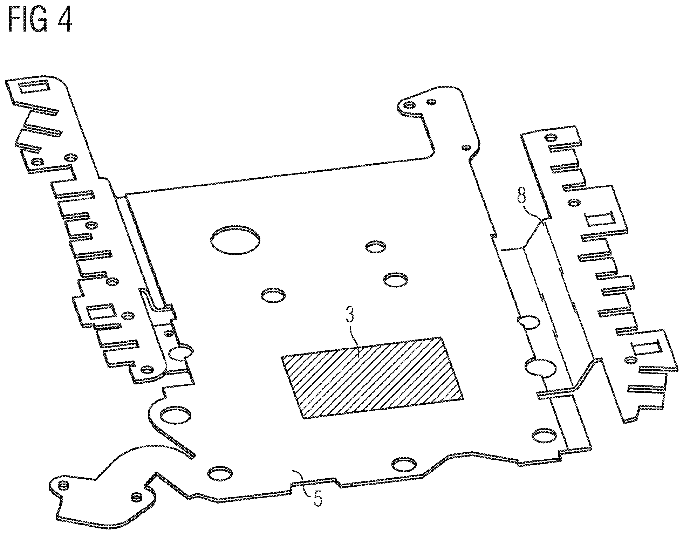

**Fig. 4** zeigt eine Signal- und Stromverteilungskomponente **5** für ein erfindungsgemäßes Gehäusekonzept **1** in einer perspektivischen Draufsicht. Bevorzugt ist die Signal- und Stromverteilungskomponente **5** aus einer mehrlagigen PCB-Leiterplatte aufgebaut, die einen elektrisch isolierenden Kern und zwei darauf aufgebrachte Kupferbeschichtungen aufweist. Alternativ kann gleichermaßen eine PCB-Leiterplatte mit einem Kern und nur einer Kupferbeschichtung verwendet werden. Der Aufsatzbereich **3** für den in den Figuren 1 bis 3 gezeigten Schaltungsträger **4** ist vorliegend schraffiert dargestellt. Darüber hinaus können auch bei der Signal- und Stromverteilungskomponente **5** dreidimensionale Strukturen **8** beispielsweise durch Biegen mit oder ohne Tiefenfräsung ausgebildet werden. Dadurch und durch die Möglichkeit der Stanzung der Komponente ist eine flexible Anpassung an die applikationsspezifischen Vorgaben zur Dimensionierung und zur Architektur gegeben.

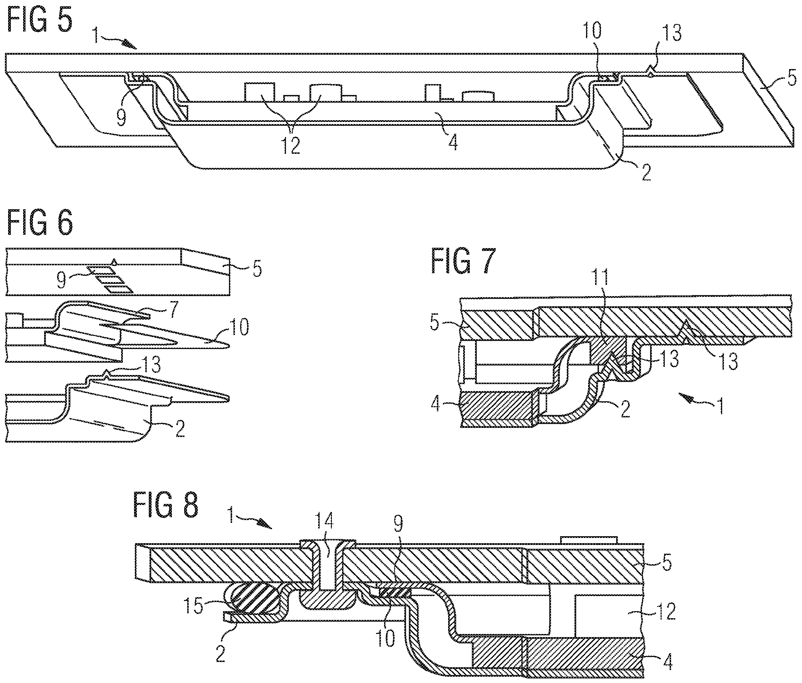

**Fig. 5** zeigt in einer perspektivischen Schnittansicht ein erfindungsgemäßes Gehäusekonzept **1.** Der Schaltungsträger **4** bestückt mit den elektronischen Bauteilen **12** der zentralen Steuerungselektronik ist in seinen Randbereichen **7** nach oben gebogen, so dass eine flächige Anlage zu der darüber angeordneten Signal- und Stromverteilungskomponente **5** entsteht. Der wannenförmige Gehäuseboden **2** ist bevorzugt ein Stanzbiegeteil aus Aluminium und nimmt den Schaltungsträger **4** vollständig auf. In seinen Randbereichen ist der wannenförmige Gehäuseboden an der darüber angeordneten Signal- und Stromverteilungskomponente **5** befestigt. Die Befestigung kann bevorzugt mittels Laminierung **10** erfolgen. Zusätzlich können auch weitere mechanische Befestigungen wie Nasen **13,** Noppen, Schrauben oder Nieten **14** vorgesehen sein. Der wannenförmige Gehäuseboden **2** fungiert gleichzeitig als Wärmesenke für den darin angeordneten Schaltungsträger **4,** der daher bevorzugt mittels Wärmeleitkleber an dem Gehäuseboden befestigt ist.

**Fig. 6** zeigt in einer explodierten Detailansicht den Randbereich eines erfindungsgemäßen Gehäusekonzepts **1** aus **Fig. 5****.** Die Signal- und Stromverteilungskomponente **5** weist Lötkontaktbereiche **9** zur Anbindung des Schaltungsträgers **4** auf. Der Schaltungsträger **4** bestückt mit elektronischen Bauteilen **12** ist in seinem Randbereich **7** nach oben gebogen, was durch eine Tiefenfräsung **6** der entsprechenden Bereiche ermöglicht wird. Dadurch kann er in diesen Bereichen beispielsweise mittels Dichtungskleber in Form einer Epoxy- oder Acrylkleberfolie durch Laminierung **10** auf dem Gehäuseboden **2** befestigt werden. Der wannenförmige Gehäuseboden **2** ist bevorzugt als Stanzbiegeteil aus Aluminium gefertigt und nimmt den Schaltungsträger **4** bestückt mit den elektronischen Bauteilen **12** auf. Er weist an seinem Kanten einen flächigen Bereich zur Laminierung auf die Signal- und Stromverteilungskomponente **5** mit Dichtungskleber in Form einer Epoxy- oder Acrylkleberfolie auf. Gleichermaßen kann ein flüssiger Kleber in Form einer Raupe aufgebracht werden. Gleichzeitig ist zudem ein Vorsprung zum Einrasten von korrespondierenden Nasen **13** des Gehäusebodens **2** in eine entsprechende Vertiefung der Signal- und Stromverteilungskomponenten vorgesehen, so dass eine weitere mechanische Stabilisierung erreicht wird.

**Fig. 7** und **Fig. 8** zeigen Detail-Schnittansichten von alternativen Varianten eines Gehäusekonzepts **1.** In

**Fig. 7** umfasst das erfindungsgemäße Gehäusekonzept in dem wannenförmigen Gehäuseboden **2** mit eingesetztem Schaltungsträger **4** und darauf befestigter Signal- und Stromverteilungskomponente **5** die Ausbildung weiterer Nasen **13,** die in die entsprechenden Aussparungen einerseits im Kantenbereich **11** in ursprünglicher Dicke des Schaltungsträgers **4** und andererseits in der Signal- und Stromverteilungskomponente **5** eingreifen können. Alternativ aber nicht erfindungsgemäß kann wie in **Fig. 8** gezeigt auch eine mit einer Dichtung **15** abgedichtete Befestigung des Gehäusebodens **2** an der Signal-und Stromverteilungskomponente **5** erfolgen. Neben der Laminierung **10** des Schaltungsträgers **4** ist gleichzeitig eine weitere mechanische Befestigung in Form einer Niete **14** vorgesehen. Durch diesen alternativen Aufbau kann eine verbesserte Dichtungswirkung auch für mit der einfachen Laminierung unverträglichen Umgebungen wie beispielsweise speziellen Getriebeölen erzielt werden.

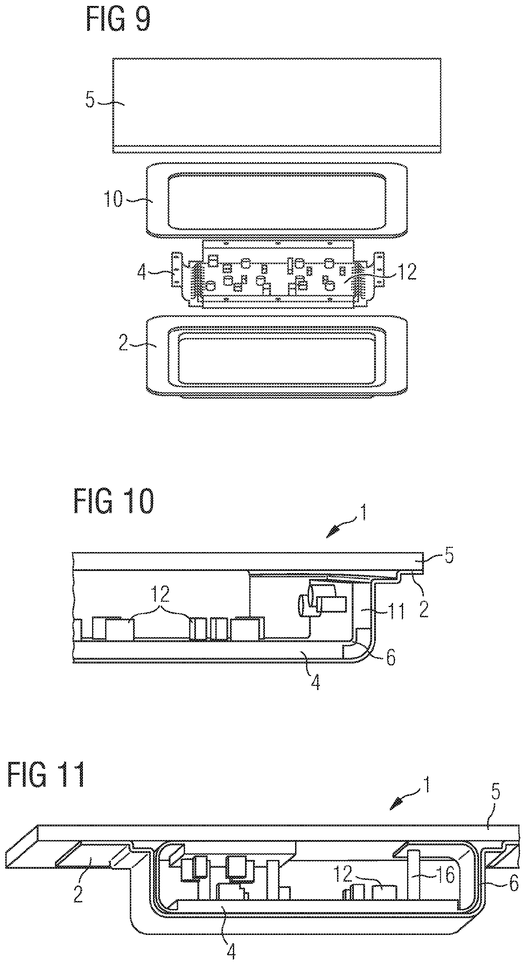

**Fig. 9** zeigt in einer explodierten perspektivischen Draufsicht eine weitere Ausgestaltung, die keine Ausführungsform der Erfindung darstellt. In den wannenförmigen Gehäuseboden **2** wird ein Schaltungsträger **4** eingesetzt, der im Gegensatz zu den Ausführungen in den vorhergehenden Zeichnungen ein keramisches Substrat **12** als elektronisches Bauteil Schaltungsträger **4** aufweist. Das keramische Substrat **12** ist innerhalb einer Aussparung des Schaltungsträgers **4** angeordnet und mit diesem durch Dickdrahtbondungen verbunden. Der Schaltungsträger **4** weist nach oben gebogene Randbereiche **7** auf, die erfindungsgemäß die Kontaktstellen **9** zur Anbindung an die Signal- und Stromverteilungskomponente **5** tragen. Alternativ kann der Schaltungsträger **4** auch mehrstückig ausgestaltet sein und einzelne Schenkel können über Bondungen mit dem keramischen Substrat verbunden sein. Je nach Aufbau des keramischen Substrates ist es auf diese Weise zum Beispiel möglich, nur einen oder zwei Teilstücke des Schaltungsträgers **4** ein zu setzten, was zu einer deutlichen Materialeinsparung führen kann. In dieser Hinsicht ist es weiterhin bevorzugt, einen zweilagigen Schaltungsträger mit einem Kern und einer Kupferbeschichtung einzusetzen. Über eine Laminierung **10** wird die Signal- und Stromverteilungskomponente **5** auf dem wannenförmigen Gehäuseboden **2** befestigt.

**Fig. 10 und Fig. 11** zeigen Darstellungen zweier Ausgestaltungen eines Gehäusekonzepts **1** mit verschieden ausgestalteten Randbereichen **7** der Schaltungsträger **4.** In **Fig. 10** weist der nach oben gebogene Randbereich **7** einen Kantenbereich in ursprünglicher Dicke **11** des Schaltungsträgers **4** auf. Es ist somit möglich, auch in diesem Bereich elektronische Bauteile **12** anzuordnen, so dass damit eine hinsichtlich der Wärmeverteilung und der Pfadentflechtung vorteilhafte Architektur erzielt werden kann. In **Fig. 11** sind die nach oben gebogenen Randbereiche **7** des Schaltungsträgers **4** dagegen größer dimensioniert und reichen über eine weitere Biegung bis zur dem Schaltungsträger gegenüberliegenden Horizontalen. Die Randbereiche können auch in dieser teilweise die ursprüngliche Dicke des Schaltungsträgers aufweisen und elektronische Bauteile **12** tragen. Diese elektronischen Bauteile sind damit den übrigen elektronischen Bauteilen des Schaltungsträgers gegenüber liegend angeordnet. In den Randbereichen werden bevorzugt nicht aktive elektronische Bauteile wie beispielsweise Kondensatoren angeordnet. Zur weiteren Stabilisierung können zusätzlich Abstands- und Stützelemente **16** vorgesehen werden. Mit dieser weiteren Alternative wird nochmals eine flexiblere Architektur des Gehäusekonzepts **1** ermöglicht.

Zusammenfassend wird demnach ein Gehäusekonzept für eine integrierte Steuerungselektronik vorgeschlagen, bei dem der Gehäuseboden wannenförmig ausgestaltet ist, darin der Schaltungsträger für die elektronischen Bauteile der zentralen Steuerungselektronik derart angeordnet ist, dass er durch Kontaktstellen auf mindestens einem nach oben gebogenen Randbereich elektrisch mit der darüber angeordneten Signal- und Stromverteilungskomponente verbunden werden kann, und bei dem der Gehäuseboden umlaufend mit der Signal- und Stromverteilungskomponente verbunden ist.

Durch diesen Aufbau entfällt vorteilhafterweise die Notwendigkeit für eine separate Verdeckelung des Gehäuses. Die Signal- und Potentialverteilungen ebenso wie die Trägereigenschaft für die elektronischen Bauteile können von relativ preiswerten PCB-Leiterplatten übernommen werden, so dass ein Einsatz von vergleichsweise teuren flexiblen Leiterplatten entfallen kann. Gleichzeitig kann eine Verbesserung der EMV-Abschirmwerte und der thermischen Wärmeableitung der Leistungsabwärme durch das erfindungsgemäße Gehäusekonzept erzielt werden.

Der Montageprozess kann durch die Laminierung und Verlötung der Schaltungsträger mit der darüber angeordneten Signal- und Stromverteilungskomponente in einem Schritt deutlich verkürzt werden.

Die Montage ist zudem leicht und kostengünstig in den Gesamtmontageprozess einer elektronischen Vorrichtung integrierbar.

## Patentansprüche

1. Gehäusekonzept (1) für eine integrierte Steuerungselektronik mit einem Gehäuseboden (2), einem Schaltungsträger (4) bestückt mit elektronischen Bauteilen (12) der zentralen Steuerungselektronik (12) und einer Signal- und Stromverteilungskomponente (5) als elektrischer Verbindung zwischen der zentralen Steuerungselektronik (12) und peripheren Komponenten, wobei der Gehäuseboden (2) wannenförmig ausgestaltet ist, darin der Schaltungsträger (4) für die elektronischen Bauteile (12) der zentralen Steuerungselektronik derart angeordnet ist, und wobei der Schaltungsträger (4) durch Kontaktstellen (9) auf mindestens einem nach oben gebogenen Randbereich (7) elektrisch mit der darüber angeordneten Signal- und Stromverteilungskomponente (5) verbunden ist , **dadurch gekennzeichnet, dass** der Gehäuseboden (2) umlaufend mit der Signal- und Stromverteilungskomponente (5) verbunden ist, indem er auf die Signal- und Stromverteilungskomponente (5)laminiert ist und gleichzeitig Nasen (13) des Gehäusebodens (2) in eine entsprechende Vertiefung der Signal- und Stromverteilungskomponenten (5) eingerastet sind.

2. Gehäusekonzept (1) nach Anspruch 1, **dadurch gekennzeichnet, dass** die Signal- und Stromverteilungskomponente (5) zwei- oder mehrlagig ist.

3. Gehäusekonzept (1) nach Anspruch 2, **dadurch gekennzeichnet, dass** die mehrlagige Signal- und Stromverteilungskomponente (5) ihrerseits verschiedene Kontaktstellen zur elektronischen Anbindung der peripheren Komponenten aufweist.

4. Gehäusekonzept (1) nach Anspruch 2 oder 3, **dadurch gekennzeichnet, dass** der Schaltungsträger (4) einstückig oder mehrstückig ausgeführt ist.

5. Gehäusekonzept (1) nach einem der vorhergehenden Ansprüche, **dadurch gekennzeichnet, dass** die elektronischen Bauteile (12) der zentralen Steuerungselektronik mittels Lötverfahren, Kleben oder Bonden auf dem Schaltungsträger (4) befestigt und/oder kontaktiert sind.

6. Gehäusekonzept (1) nach einem der vorhergehenden Ansprüche, **dadurch gekennzeichnet, dass** die elektronischen Bauteile (12) der zentralen Steuerungselektronik in den Schaltungsträger (4) integriert und/oder mit dem Schaltungsträger vergossen sind.

7. Verfahren zur Herstellung eines Gehäusekonzepts (1) mit den Merkmalen mindestens eines der vorhergehenden Ansprüche, wobei ein Schaltungsträger (4) mit den elektronischen Bauteilen (12) der zentralen Steuerungselektronik bestückt wird, in einen wannenförmigen Gehäuseboden (2) eingebracht wird, optional mit einem Vergussmaterial vergossen wird und eine darüber angeordnete Signal- und Stromverteilungskomponente (5) in einem Schritt sowohl elektrisch mit dem Schaltungsträger (4) als auch mechanisch mit den wannenförmigen Gehäuseboden (2) verbunden wird, indem der Gehäuseboden (2) auf die Signal- und Stromverteilungskomponente (5)laminiert wird und gleichzeitig Nasen (13) des Gehäusebodens (2) in eine entsprechende Vertiefung der Signal- und Stromverteilungskomponenten (5) einrasten.

8. Verwendung eines Gehäusekonzepts (1) nach einem der vorhergehenden Ansprüche 1 bis 6 bevorzugt für eine integrierte Getriebesteuerung eines Kraftfahrzeugs.

## Claims

1. Housing design (1) for integrated control electronics having a housing base (2), a circuit carrier (4) fitted with electronic assemblies (12) of the central control electronics (12) and a signal and power distribution component (5) as electrical connection between the central control electronics (12) and peripheral components, wherein the housing base (2) is configured in the shape of a trough, the circuit carrier (4) for the electronic assemblies (12) of the central control electronics being arranged in such a manner in said housing base, and wherein the circuit carrier (4) is electrically connected to the signal and power distribution component (5) arranged above said circuit carrier by contact points (9) on at least one upwardly bent edge region (7), **characterized in that** the housing base (2) is connected to the signal and power distribution component (5) peripherally, by virtue of the fact that said housing base is laminated onto the signal and power distribution component (5) and at the same time lugs (13) of the housing base (2) are latched into a corresponding recess in the signal and power distribution components (5).

2. Housing design (1) according to Claim 1, **characterized in that** the signal and power distribution component (5) is twolayered or multi-layered.

3. Housing design (1) according to Claim 2, **characterized in that** the multi-layered signal and power distribution component (5) itself has various contact points for electronic connection of the peripheral components.

4. Housing design (1) according to Claim 2 or 3, **characterized in that** the circuit carrier (4) is embodied in one piece or in various pieces.

5. Housing design (1) according to one of the preceding claims, **characterized in that** the electronic assemblies (12) of the central control electronics are fixed and/or contact-connected to the circuit carrier (4) by means of soldering methods, gluing or bonding.

6. Housing design (1) according to one of the preceding claims, **characterized in that** the electronic assemblies (12) of the central control electronics are integrated into the circuit carrier (4) and/or encapsulated with the circuit carrier.

7. Method for producing a housing design (1) having the features of at least one of the preceding claims, wherein a circuit carrier (4) is fitted with the electronic assemblies (12) of the central control electronics, is inserted into a trough-shaped housing base (2), is optionally encapsulated with a potting material and a signal and power distribution component (5) arranged above said circuit carrier is connected in one step both electrically to the circuit carrier (4) and mechanically to the trough-shaped housing base (2), by virtue of the fact that the housing base (2) is laminated onto the signal and power distribution component (5) and at the same time lugs (13) of the housing base (2) latch into a corresponding recess in the signal and power distribution components (5).

8. Use of a housing design (1) according to one of the preceding Claims 1 to 6 preferably for an integrated transmission controller of a motor vehicle.

## Revendications

1. Concept de boîtier (1) destiné à une électronique de commande intégrée, comportant un fond de boîtier (2), un porte-circuit (4) équipé de composants électroniques (12) de l'électronique de commande centrale (12) et un composant de distribution de signal et de courant (5) servant de connexion électrique entre l'électronique de commande centrale (12) et des composants périphériques, dans lequel le fond de boîtier (2) est réalisé sous la forme d'une cuve et en ce que le porte-circuit (4) destiné aux composants électroniques (12) de l'électronique de commande centrale est disposé dans celui-ci de telle manière que le porte-circuit (4) soit connecté électriquement par des points de contact (9), sur au moins une partie de bord (7) incurvée vers le haut, au composant de distribution de signal et de courant (5), **caractérisé en ce que** le fond de boîtier (2) est connecté de manière circonférentielle au composant de distribution de signal et de courant (5) en faisant en sorte qu'il soit stratifié sur le composant de distribution de signal et de courant (5) et que des cliquets (13) du fond de boîtier (2) s'encliquètent simultanément dans un évidement correspondant des composants de distribution de signal et de courant (5).

2. Concept de boîtier (1) selon la revendication 1, **caractérisé en ce que** le composant de distribution de signal et de courant (5) est en deux exemplaires ou plus.

3. Concept de boîtier (1) selon la revendication 2, **caractérisé en ce que** le composant de distribution de signal et de courant (5) en plusieurs exemplaires présente de son côté des points de contact différents pour le raccordement électrique des composants périphériques.

4. Concept de boîtier (1) selon la revendication 2 ou 3, **caractérisé en ce que** le porte-circuit (4) est réalisé en une seule pièce ou en plusieurs pièces.

5. Concept de boîtier (1) selon l'une quelconque des revendications précédentes, **caractérisé en ce que** les composants électroniques (12) de l'électronique de commande centrale sont fixés et/ou mis en contact avec le porte-circuit (4) par un procédé de brasage, par collage ou par soudage.

6. Concept de boîtier (1) selon l'une quelconque des revendications précédentes, **caractérisé en ce que** les composants électroniques (12) de l'électronique de commande centrale sont intégrés dans le porte-circuit (4) ou sont encapsulés avec le porte-circuit.

7. Procédé de fabrication d'un concept de boîtier (1) présentant les caractéristiques d'au moins l'une des revendications précédentes, dans lequel un porte-circuit (4) est équipé des composants électroniques (12) de l'électronique de commande centrale, est introduit dans un fond de boîtier (2) en forme de cuve, est facultativement encapsulé avec un matériau d'encapsulation et en ce que, lors d'une étape, le composant de distribution de signal et de courant (5) disposé sur celui-ci est connecté tant électriquement au porte-circuit (4) que mécaniquement au fond de boîtier (2) en forme de cuve, en faisant en sorte que le fond de cuve (2) soit stratifié sur le composant de distribution de signal et de courant (5) et que des cliquets (13) du fond de boîtier (2) s'encliquètent simultanément dans un évidement correspondant des composants de distribution de signal et de courant (5).

8. Utilisation d'un concept de boîtier (1) selon l'une quelconque des revendications 1 à 6 précédentes, de préférence destiné à une commande de transmission intégrée d'un véhicule automobile.
